# EUROPEAN PATENT SPECIFICATION

(11) **EP 2 450 951 B1**
(45) Date of publication and mention of the grant of the patent: **25.11.2020**
(21) Application number: 11185950.0
(22) Date of filing: 20.10.2011
(51) Int. Cl.: H01L 23/00, H01L 23/31, H01L 23/495

(54) **Quad flat package with exposed paddle**
Quadratisches Chipgehäuse mit offenliegender Bondinsel
Boîtier plat quadruple doté d'une pale exposée

(30) Priority: 08.11.2010 KR 20100110309
(43) Date of publication of application: 09.05.2012
(73) Proprietor: Hewlett-Packard Development Company, L.P., Spring, TX 77389 (US)
(72) Inventor: Park, Seung-hun, Gyeonggi-do (KR); Jung, Dong-yeol, Gyeonggi-do (KR)
(74) Representative: Hewett, Jonathan Michael Richard

(56) References cited:
- EP-A1- 0 658 074
- EP-A2- 1 858 080
- WO-A1-2004/073063
- KR-A- 20080 080 884
- US-A- 5 155 904
- US-A1- 2007 052 070
- US-A1- 2007 085 199
- US-A1- 2009 289 335

## Description

The present invention relates to an integrated circuit package and more particularly to a quad flat package (QFP) with an exposed paddle. QFPs are disclosed e.g. by WO2004/073063 A1, EP1858080 A2, US2007/052070 A1, and KR20080080884 A.

A quad flat package (QFP) is an integrated circuit package which generally has a rectangular body and a plurality of leads extending from four sides thereof. The QFP generally has a paddle which may be exposed to outside from underneath the QFP. In such a QFP, which is usually called eQFP (exposed QFP), the exposed paddle is generally used for ground connection.

In order to mount an integrated circuit package onto a board, generally, reflow soldering and wave soldering are applied. In reflow soldering, solder cream is used to attach electronic components to be mounted onto the board temporarily, and the electronic components are mounted onto the board as heat is supplied to the entire assembly at a later stage to fuse the solder cream. In wave soldering, the board with the electronic components attached thereto is contacted with the fused solder so that the electronic components are mounted on the board.

It has been generally reported that the reflow soldering costs approximately 21% more than the wave soldering process. Accordingly, especially for low price electric devices, it would be preferable to use the wave soldering to reduce costs. The wave soldering is also preferred in the case of making test models at an early developmental stage to reduce cost of research and development.

However, wave soldering is not currently applied to the process of mounting an eQFP, but rather reflow soldering is applied which has a relatively higher cost. This is because the wave soldering does not solder the exposed paddle of the eQFP. That is, in wave soldering, the fused solder does not penetrate into the area of the exposed paddle through minute spaces between the lower surface of the eQFP and the upper surface of the board.

Therefore, it is necessary to develop an eQFP which can be processed by wave soldering.

The present invention consists in a quad flat package according to the subject-matter of claim 1. Preferred embodiments are defined by the additional features according to dependent claims 2 - 9.

A quad flat package (QFP) is provided, which may include a semiconductor chip, a paddle to support the semiconductor chip, a molding portion to surround the semiconductor chip, a plurality of leads formed on four sides of the molding portion, and a plurality of bonding wires to electrically connect the plurality of leads to the semiconductor chip, wherein the paddle is exposed to outside from at least one corner of a lower surface of the molding portion.

The paddle includes a paddle center arranged below the semiconductor chip to support the semiconductor chip, at least one paddle terminal end is arranged on the at least one corner of the lower surface of the molding portion, and at least one paddle connection connects the paddle center to the at least one paddle terminal end.

The plurality of bonding wires include a first bonding wire that electrically connects a lead that corresponds to the ground among the plurality of leads, to the at least one paddle connection, and a second bonding wire that electrically connects the paddle center to the semiconductor chip.

The paddle may be exposed to outside at four corners of the lower surface of the molding portion.

The paddle center, the at least one paddle terminal end and the at least one paddle connection may be all exposed to outside.

Only the at least one paddle terminal end may be exposed to outside.

The paddle center may have an area more than twice as large as the semiconductor chip.

The QFP may additionally include an adhesive material to attach the semiconductor chip to the paddle.

In another embodiment, a printed circuit board assembly is provided, which includes the QFP characterized as explained above, and a board onto which the QFP is mounted.

The board may be a single layer board.

The above and/or other aspects of the present invention will be more apparent by describing certain exemplary embodiments of the present invention with reference to the accompanying drawings, in which:
FIG. 1 is a schematic plan view of a quad flat package (QFP);
FIG. 2 is a schematic bottom view of the QFP of FIG. 1;
FIG. 3 is a schematic side view of the QFP of FIG. 1;
FIG. 4 is a schematic view of an interior of the QFP according to a first embodiment;
FIG. 5 is a schematic cross-section view taken on lines V-V of FIG. 4;
FIGS. 6 to 9 illustrate the result of test of signal quality, power quality and EMI characteristics obtained when a QFP according to the first embodiment and a conventional QFP with exposed pad are mounted on a board by wave soldering;
FIG. 10 is a schematic bottom view of a QFP according to a second embodiment; and
FIG. 11 is a schematic bottom view of a QFP according to a third embodiment.

Certain exemplary embodiments of the present invention will now be described in greater detail with reference to the accompanying drawings.

In the following description, same drawing reference numerals are used for the same elements even in different drawings. The matters defined in the description, such as detailed construction and elements, are provided to assist in a comprehensive understanding of the present invention. Also, for better understanding of embodiments, the accompanied drawings may not be on the actual scales and some elements may be illustrated with exaggerated dimensions.

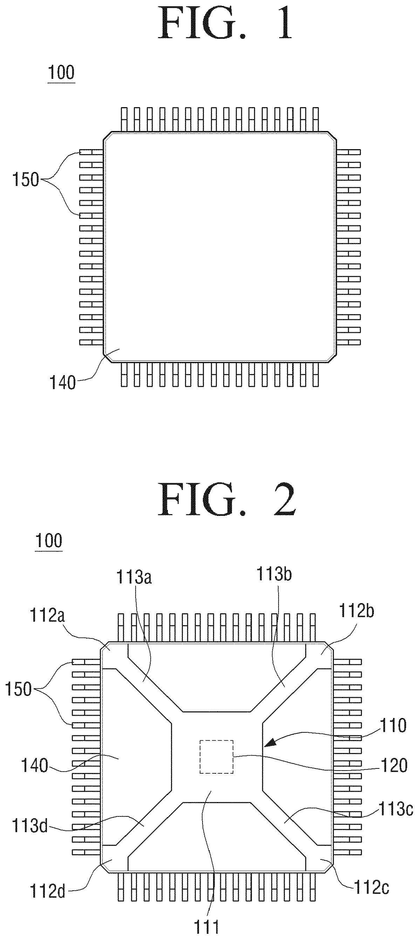

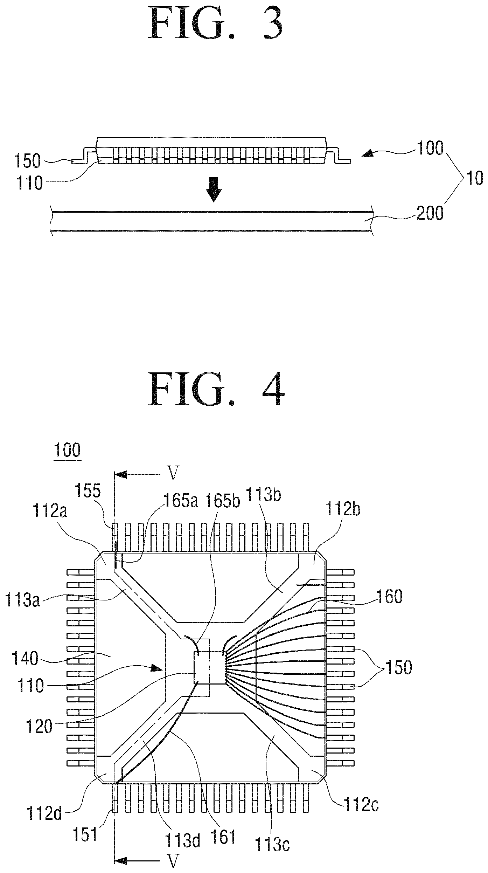

FIG. 1 is a schematic plane view of a quad flat package (QFP) 100, FIG. 2 is a schematic bottom view of the QFP 100 of FIG. 1, and FIG. 3 is a schematic side view of the QFP 100 of FIG. 1.

Referring to FIG. 2, the QFP 100 may be a so-called eQFP in which a paddle 110 is exposed from underneath the QFP 100. FIG. 3 particularly illustrates the QFP 100 with a board 200 onto which the QFP 100 is mounted. A printed board assembly (PBA) 10 is completed as the QFP 100 is mounted on the board 200 by soldering. Although only one QFP 100 is shown for the purpose of illustration, it should be appreciated that a plurality of QFPs along with a variety of electronic devices can also be mounted on the board 200.

In view of an object to apply wave soldering with more economical cost to the eQFP, the board 200 may preferably be a 1-layer board which is relatively economical.

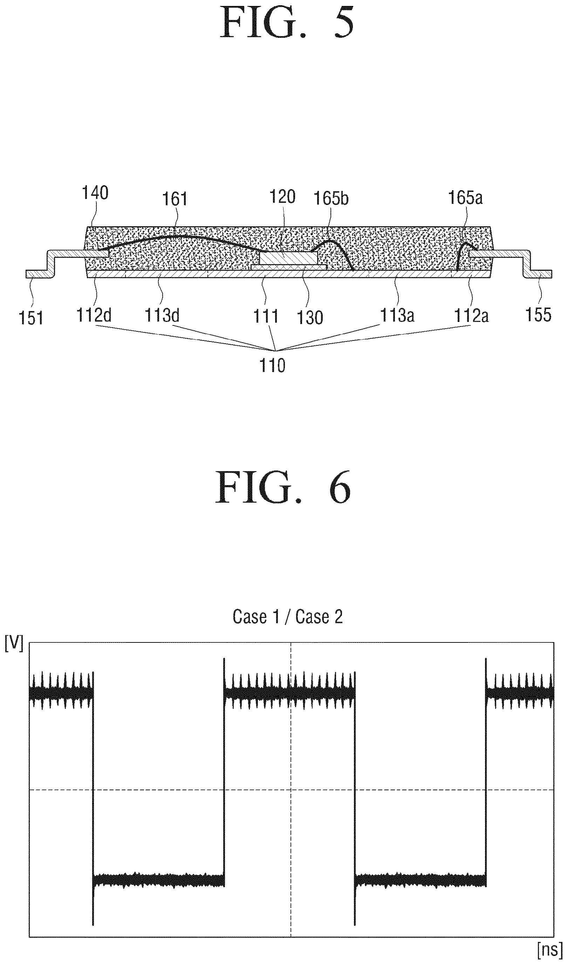

The QFP 100 according to a first embodiment will be explained in greater detail below with reference to FIGS. 4 and 5. FIG. 4 is a schematic view of an interior of the QFP according to the first embodiment, and FIG. 5 is a schematic cross-section view taken on lines V-V of FIG. 4. Referring to FIG. 4, it should be recognized that part of a molding portion 140, located above the paddle 110, is removed to illustrate the paddle 110 and a bonding wire 160.

The paddle 110 supports a semiconductor chip 120 inside the QFP 100. It should be recognized that the paddle 110 is extended outside to a rather exaggerated height for better understanding in FIGS. 4 and 5, and that, in reality, the height of extension of the paddle 110 is considerably smaller than illustrated.

An adhesive material 130 attaches the semiconductor chip 120 to the paddle 110.

The molding portion 140 surrounds the semiconductor chip 120 to protect the semiconductor chip 120 from the external environment. The molding portion 140 may be formed as, for example, a plastic mold compound such as epoxy mold compound (EMC).

A plurality of leads 150 are formed on four sides of the molding portion 140. The leads 150 extend outside to provide electric connection with the board 200. To this end, a plurality of lands (not illustrated) are formed on the board 200 at locations corresponding to the plurality of leads 150, and the plurality of leads 150 can be soldered onto the corresponding lands, respectively. Herein, the number of the plurality of leads 150 illustrated in the drawings is arbitrarily chosen for simplicity of the illustrations. That is, the number of the leads 150 generally can be from 32 to 304 in actual implementation.

A plurality of bonding wires 160 electrically connects the plurality of leads 150 to the semiconductor chip 120. For simplicity of illustration, FIG. 4 only illustrates part of the bonding wires 160. Therefore, in actual implementation, there are more bonding wires 160 respectively corresponding to the plurality of leads 150. Further, a plurality of electrodes (not illustrated) is also formed on the semiconductor chip 120 for connection with the plurality of bonding wires 160.

Referring to FIGS. 2, 4 and 5, the paddle 110 may include a paddle center 111, first to fourth paddle terminal ends 112a to 112d, and first to fourth paddle connections 113a to 113d.

The paddle center 111 may be arranged below the semiconductor chip 120 to support the semiconductor chip 120. The first to fourth paddle terminal ends 112a to 112d may be arranged on four corners of a lower surface of the molding portion 140. The first to fourth paddle connections 113a to 113d may connect the first to fourth paddle terminal ends 112a to 112d to the paddle center 111. In one embodiment, all of the paddle center 111, the first to fourth paddle terminal ends 112a to 112d and the first to fourth paddle connections 113a to 113d may be exposed to outside from the lower surface of the molding portion 140.

The paddle may be electrically connected to a ground pad (not illustrated) formed on the board 200 to act as a ground. Since the paddle 110 serves to reinforce the ground, the signal quality, power quality and electro magnetic interference (EMI) characteristics of the QFP 100 improve. In one embodiment, in order to further increase the reinforcement of ground of the paddle 110, the paddle center 111 is designed to have a two times larger area than that of the semiconductor chip 120.

In order to electrically connect the paddle 110 to the ground pad formed on the board 200, soldering is necessary. As explained above, the wave soldering is not applicable to a conventional eQFP. This is because in a conventional eQFP, the exposed paddle is located on a lower center portion of the eQFP, and it is thus difficult for the fused solder to penetrate into the area of the exposed paddle through such a minute space between the lower surface of the eQFP and the upper surface of the board.

In the first embodiment, however, it is possible to apply the wave soldering. That is, since the first to fourth paddle terminal ends 112a to 112d are arranged on the corners of the lower surface of the molding portion 140, the fused solder can penetrate into the first to fourth paddle terminal ends 112a to 112d. In this case, the ground pad on the board 200 may be formed at an area where the fused solder can penetrate. The ground pad may be formed on area corresponding to the first to fourth paddle terminal ends, or a broader area that includes the area corresponding to the first to fourth paddle terminal ends 112a to 112d. The ground pad may be formed in the same shape as the paddle 110.

Although four paddle terminal ends 112a to 112d are used in the first embodiment, this is drawn only for illustrative purposes. Therefore, it should be recognized that the number of the paddle terminal ends may be varied as necessary. For example, one to three paddle terminal ends may be used unlike this embodiment. As long as the paddle 110 is exposed to outside from at least one corner of the lower surface of the molding portion 140, it does not influence the performance of wave soldering.

Referring to FIGS. 4 and 5, the bonding wires indicated by reference numeral '161' may electrically connect one 151 of the leads to the semiconductor chip 120 directly. The lead 151 may be a signal lead to transmit and receive a signal, a power lead to receive power, or a ground lead corresponding to a ground.

Referring to FIGS. 4 and 5, the lead indicated by reference numeral '155' may be connected to the semiconductor chip 120 by first and second bonding wires 165a, 165b. The lead 155 may be the ground lead. That is, the first bonding wire 165a may electrically connect the ground lead 155 to the first paddle connection 113a, and the second bonding wire 165b may electrically connect the paddle center 111 to the semiconductor chip 120. In other words, the ground lead 155 may be electrically connected to the semiconductor chip 120 via the paddle 110. Accordingly, the paddle 110 may take the role of a ground. In this example, all the ground leads 155, the paddle 110, and the ground pad formed on the board 200 may have the same ground potential.

Generally, inductance and noise increase as the length of bonding wire increases. In the first embodiment, the ground lead 155 is electrically connected to the first paddle connection 113a adjacent to the ground lead 155 by the first bonding wire 165a, and the semiconductor chip 120 is electrically connected to the paddle center 111 adjacent to the semiconductor chip 120 by the second bonding wire 165b. Therefore, compared to a case in which the ground lead 155 is directly connected to the paddle center 111 which is relatively farther away from the ground lead 155, the first embodiment allows the bonding wire to have reduced length for ground connection and subsequently noise can be reduced.

It should be recognized that only one ground lead 155 is illustrated in FIGS. 4 and 5 for simplicity of illustration. In actual implementation, a plurality of ground leads 155 may be used and at many different locations.

Hereinbelow, the test result regarding the comparison of signal quality, power quality and EMI characteristics between the QFP 100 according to the first embodiment and the conventional QFP with exposed pad, each mounted on the board by wave soldering, will be explained. For simplicity of explanation, 'case 1' hereinbelow refers to an example in which the QFP 100 according to the first embodiment is mounted on the board 200 by wave soldering, and 'case 2' refers to an example in which the conventional QFP with exposed pad is mounted on the board 200 by wave soldering. Unlike the QFP of the first embodiment, the conventional QFP has the exposed pad formed only on the center of the lower surface of the QFP.

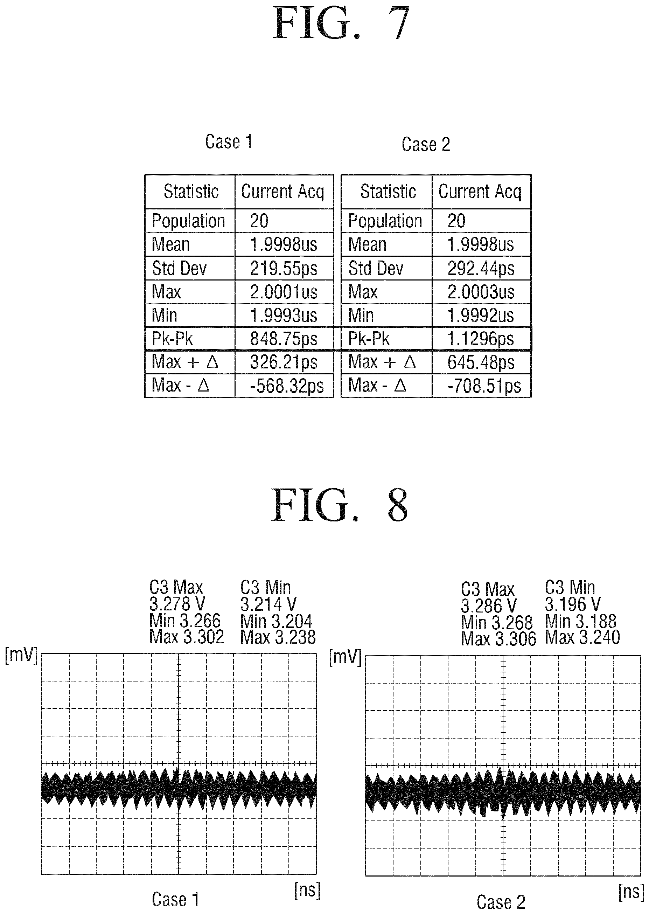

Referring to FIGS. 6 and 7, the result of comparing signal quality between case 1 and case 2 will be explained.

FIG. 6 illustrates PWM clock waveform measured from a specific lead of case 1 and case 2. For the test, DSA 71254 digital serial analyzer (12.5 GHz) and p7240 probe (4 GHz) produced by Tektronix were used. Referring to FIG. 6, both of case 1 and case 2 illustrate almost similar waveforms and a difference is hardly noticeable. Accordingly, jittering of case 1 and case 2 was measured using a jitter analyzer.

FIG. 7 illustrates the result of jitter analysis of case 1 and case 2. Case 1 exhibited Pk-Pk jittering of 848.75 ps, and case 2 exhibited Pk-Pk jittering of 1129.6 ps. That is, case 1 has 24.86% reduced jittering compared to case 2. It was therefore confirmed that case 1 has enhanced signal quality from that of case 2.

Referring to FIG. 8, the result of comparing power quality between case 1 and case 2 will be explained. FIG. 8 is a graphical form of the measurement of voltage ripples of case 1 and case 2. The voltage ripples were measured from 3.3V memory end of the board when the memory block was activated, using TDS 784D oscilloscope (1 GHz) and p6245 probe (1.5 GHz) produced by Tektronix. Case 1 exhibited voltage ripple of 98 mV (3.302 V - 3.204 V), and case 2 exhibited voltage ripple of 118 mV (3.306 V - 3.188 V). It was thus confirmed that case 1 has approximately 16.95% reduced voltage ripple compared to case 2. Accordingly, it was confirmed that case 1 had more increased power quality than case 2.

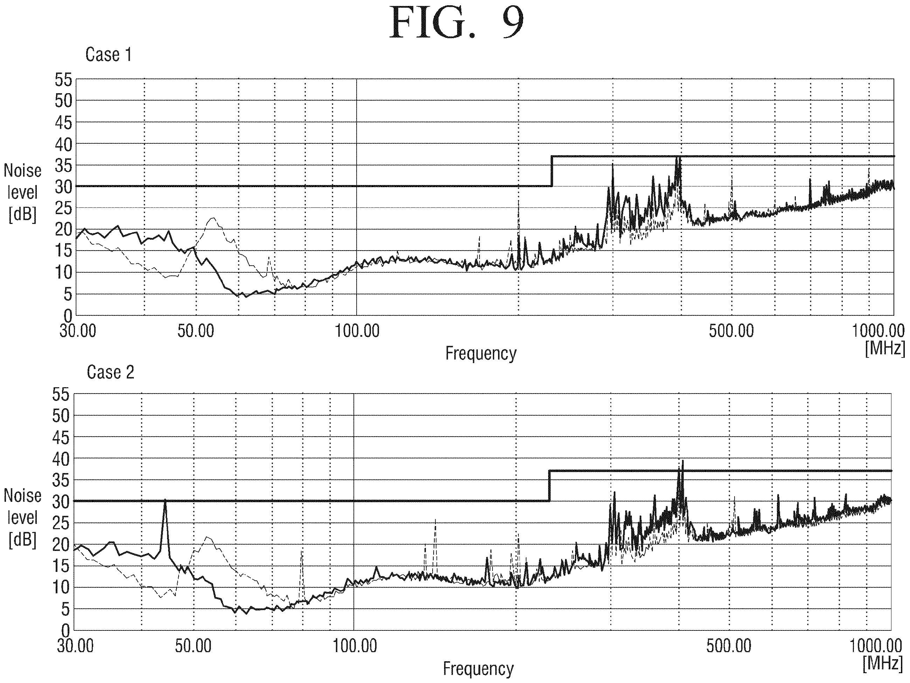

Referring to FIG. 9, the result of comparing EMI characteristics of case 1 and case 2 will be explained. FIG. 9 is a graphical form of the EMI measurements of case 1 and case 2. The 3 meter anechoic chamber was used in this test. In FIG. 9, a thick solid line represents Class B which is EMI regulation standard, a thin line represents horizontal noise, and a dotted line represents vertical noise. Over the entire frequency band, case 1 exhibits lower noise emission than that of case 2. When memory clock frequency is 100 MHz and system core frequency is 300 MHz, it is 300 MHz that is weakest to EMI in the frequency band. At the frequency of 300 MHz, case 1 exhibited noise level of 33.2 dB, and case 2 exhibited noise level of 34.7 dB. It was thus confirmed that case 1 had approximately 1.5 dB reduced noise level than case 2 at the frequency of 300 MHz. Accordingly, it was confirmed that case 1 had more improved EMI characteristic than case 2.

As explained above, it was confirmed that case 1 had more improved signal quality, power quality and EMI characteristics than case 2. This is possible because the paddle 110 of the QFP 100 reinforces the ground in the first embodiment. The test result also means that the paddle 100 is soldered stably onto the ground pad formed on the board 200 by wave soldering without using reflow soldering. Compared to this, the conventional QFP having exposed pad cannot be soldered onto the ground pad formed on the board 200 and accordingly exhibited poorer signal quality, power quality and EMI characteristics than the QFP 100 of the first embodiment.

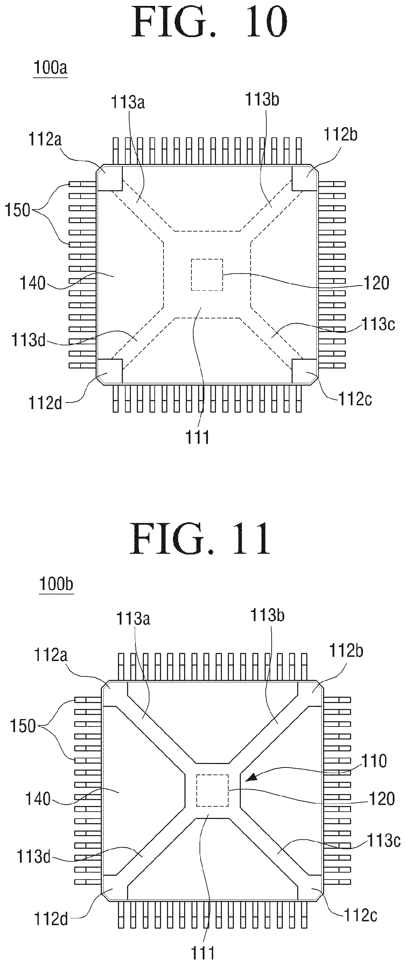

FIG. 10 is a schematic bottom view of a QFP 100a according to a second embodiment. The like elements with the same functions with those explained above with reference to the first embodiment will be designated with the same reference numerals and explanation thereof will be omitted for the sake of brevity.

The difference of the second embodiment from the first embodiment is that only the first to fourth pad terminal ends 112a to 112d are exposed to outside, while the paddle center 111 and the first to fourth paddle connections 113a to 113d are not exposed to outside. In this embodiment, since the first to fourth paddle terminal ends 112a to 112d are arranged on the corners of the lower surface of the molding portion 140, fused solder can penetrate to the first to fourth terminal ends 112a to 112d and it is thus possible to apply the wave soldering.

In one embodiment, four paddle terminal ends 112a to 112d are used for the illustrate purpose. Accordingly, the number of the paddle terminal ends can change as necessary. For example, one to three paddle terminal ends may be used unlike this embodiment. As long as the paddle 110 is exposed to the outside from at least one corner of the lower surface of the molding portion 140, it does not influence the performance of wave soldering.

In an alternative embodiment, the first to fourth terminal ends 112a to 112d and the first to fourth paddle connections 113a to 113d may be exposed to the outside, and the paddle center 111 may not be exposed to the outside. In another alternative embodiment, the first to fourth pad terminal ends 112a to 112d and the paddle center 111 may be exposed to the outside, while the first to fourth paddle connections 113a to 113d are not.

FIG. 11 is a schematic bottom view of a QFP 100b according to a third embodiment. The like elements with the same functions with those explained above with reference to the first embodiment will be designated with the same reference numerals and explanation thereof will be omitted for the sake of brevity.

The difference of the third embodiment from the first embodiment is that the paddle center 11 has a reduced area to reduce manufacture cost of the QFP 100b. In this embodiment, wave soldering is also possible, since the first to fourth paddle terminals 112a to 112d are arranged on the corners of the lower surface of the molding portion 140 and thus it is possible for the fused solder to penetrate to the first to paddle terminal ends 112a to 112d.

The foregoing exemplary embodiments and advantages are merely exemplary and are not to be construed as limiting the present invention. The present teaching can be readily applied to other types of apparatuses. Also, the description of the exemplary embodiments of the present invention is intended to be illustrative, and not to limit the scope of the claims, and many alternatives, modifications, and variations will be apparent to those skilled in the art.

## Claims

1. A quad flat package (QFP) (100) comprising:
a semiconductor chip (120);
a paddle (110) to support the semiconductor chip (120);
a molding portion (140) to surround the semiconductor chip (120);
a plurality of leads (150) formed on four sides of the molding portion (140); and
a plurality of bonding wires (160) to electrically connect the plurality of leads (150) to the semiconductor chip (120), wherein the paddle (110) is exposed to outside from at least one corner of a lower surface of the molding portion (140),
such that the at least one corner of the lower surface consists only of a terminal end (112a) of the paddle (110);
wherein the paddle (110) comprises:
a paddle center (111) arranged below the semiconductor chip (120) to support the semiconductor chip (120);
the at least one paddle terminal end (112a) forming the at least one corner of the lower surface of the molding portion (140); and
at least one paddle connection (113) to connect the paddle center (111) to the at least one paddle terminal end (112a); and
**characterized in that** the plurality of bonding wires (160) comprises:
a first bonding wire (165a) that electrically connects a lead (155) that corresponds to the ground among the plurality of leads (150), to the at least one paddle connection (113); and
a second bonding wire (165b) that electrically connects the paddle center (111) to the semiconductor chip (120).

2. The QFP (100) of claim 1, wherein the paddle (110) is exposed to the outside at four corners of the lower surface of the molding portion (140).

3. The QFP (100) of claim 1 or claim 2, wherein the paddle center (111), the at least one paddle terminal end (112a) and the at least one paddle connection (113) are all exposed to the outside.

4. The QFP (100) of claim 1 or claim 2, wherein only the at least one paddle terminal end (112a) is exposed to the outside.

5. The QFP (100) of any preceding claim, wherein the paddle center (111) has an area more than twice as large as the semiconductor chip (120).

6. The QFP (100) of any one of the preceding claims, further comprising an adhesive material (130) to attach the semiconductor chip (120) to the paddle (110).

7. A printed circuit board assembly (10) comprising:
the QFP (100) of any one of the preceding claims; and
a board (200) onto which the QFP (100) is mounted.

8. The printed circuit board assembly (10) of claim 7, wherein the paddle (110) serves as a ground.

9. The printed circuit board assembly (10) of claim 7, wherein the board (200) is a single layer board (200).

## Patentansprüche

1. Quad Flat Package (QFP) (100), das Folgendes umfasst:
einen Halbleiterchip (120);
eine Bondinsel (110), um den Halbleiterchip (120) zu stützen;
einen Formteilabschnitt (140), um den Halbleiterchip (120) zu umgeben;
mehrere Zuleitungen (150), die an vier Seiten des Formteilabschnitts (140) ausgebildet sind; und
mehrere Bonddrähte (160), um die mehreren Zuleitungen (150) elektrisch mit dem Halbleiterchip (120) zu verbinden, wobei die Bondinsel (110) von wenigstens einer Ecke einer unteren Oberfläche des Formteilabschnitts (140) nach außen derart freigelegt ist, dass die wenigstens eine Ecke der unteren Oberfläche nur aus einem Terminalende (112a) der Bondinsel (110) besteht;
wobei die Bondinsel (110) Folgendes umfasst:
ein Bondinselzentrum (111), das unterhalb des Halbleiterchips (120) angeordnet ist, um den Halbleiterchip (120) zu stützen;
wobei das wenigstens eine Bondinselanschlussende (112a) die wenigstens eine Ecke der unteren Oberfläche des Formteilabschnitts (140) ausbildet; und
wenigstens eine Bondinselverbindung (113), um das Bondinselzentrum (111) mit dem wenigstens einen Bondinselanschlussende (112a) zu verbinden; und
**dadurch gekennzeichnet, dass** die mehreren Bonddrähte (160) Folgendes umfassen:
einen ersten Bonddraht (165a), der eine Zuleitung (155), die unter den mehreren Zuleitungen (150) der Masse entspricht, elektrisch mit der wenigstens einen Bondinselverbindung (113) verbindet; und
einen zweiten Bonddraht (165b), der das Bondinselzentrum (111) elektrisch mit dem Halbleiterchip (120) verbindet.

2. QFP (100) nach Anspruch 1, wobei die Bondinsel (110) an vier Ecken der unteren Oberfläche des Formteilabschnitts (140) nach außen freigelegt ist.

3. QFP (100) nach Anspruch 1 oder 2, wobei das Bondinselzentrum (111), das wenigstens eine Bondinselanschlussende (112a) und die wenigstens eine Bondinselverbindung (113) alle nach außen freigelegt sind.

4. QFP (100) nach Anspruch 1 oder 2, wobei nur das wenigstens eine Bondinselanschlussende (112a) nach außen freigelegt ist.

5. QFP (100) nach einem der vorhergehenden Ansprüche, wobei das Bondinselzentrum (111) einen Bereich aufweist, der mehr als doppelt so groß wie der Halbleiterchip (120) ist.

6. QFP (100) nach einem der vorhergehenden Ansprüche, das ferner ein Klebstoffmaterial (130) zum Befestigen des Halbleiterchips (120) an der Bondinsel (110) umfasst.

7. Leiterplattenanordnung (10), die Folgendes umfasst:
das QFP (100) nach einem der vorhergehenden Ansprüche; und
eine Platine (200), auf der das QFP (100) montiert ist.

8. Leiterplattenanordnung (10) nach Anspruch 7, wobei die Bondinsel (110) als eine Masse dient.

9. Leiterplattenanordnung (10) nach Anspruch 7, wobei die Platine (200) eine einschichtige Platine (200) ist.

## Revendications

1. Boîtier plat quadruple (QFP) (100) comprenant :
une puce semi-conductrice (120) ;
une pale (110) pour supporter la puce semi-conductrice (120) ;
une partie de moulage (140) pour entourer la puce semi-conductrice (120) ;
une pluralité de broches (150) formées sur quatre côtés de la partie de moulage (140) ; et
une pluralité de fils de liaison (160) pour connecter électriquement la pluralité de broches (150) à la puce semi-conductrice (120), dans lequel la pale (110) est exposée à l'extérieur depuis au moins un coin d'une surface inférieure de la partie de moulage (140),
de telle sorte que l'au moins un coin de la surface inférieure se compose uniquement d'une extrémité terminale (112a) de la pale (110) ;
dans lequel la pale (110) comprend :
un centre de pale (111) disposé sous la puce semi-conductrice (120) pour supporter la puce semi-conductrice (120) ;
l'au moins une extrémité terminale de pale (112a) formant l'au moins un coin de la surface inférieure de la partie de moulage (140) ; et
au moins une connexion de pale (113) pour connecter le centre de pale (111) à l'au moins une extrémité terminale de pale (112a) ; et
**caractérisé en ce que** la pluralité de fils de liaison (160) comprend :
un premier fil de liaison (165a) qui connecte électriquement une broche (155) qui correspond à la masse parmi la pluralité de broches (150), à l'au moins une connexion de pale (113) ; et
un second fil de liaison (165b) qui connecte électriquement le centre de pale (111) à la puce semi-conductrice (120).

2. QFP (100) selon la revendication 1, dans lequel la pale (110) est exposée à l'extérieur à quatre coins de la surface inférieure de la partie de moulage (140).

3. QFP (100) selon la revendication 1 ou la revendication 2, dans lequel le centre de pale (111), l'au moins une extrémité terminale de pale (112a) et l'au moins une connexion de pale (113) sont tous exposés à l'extérieur.

4. QFP (100) selon la revendication 1 ou la revendication 2, dans lequel seul l'au moins une extrémité terminale de pale (112a) est exposée à l'extérieur.

5. QFP (100) selon l'une quelconque des revendications précédentes, dans lequel le centre de pale (111) a une surface plus de deux fois plus grande que la puce semi-conductrice (120).

6. QFP (100) selon l'une quelconque des revendications précédentes, comprenant en outre un matériau adhésif (130) pour fixer la puce semi-conductrice (120) à la pale (110).

7. Ensemble de carte de circuit imprimé (10) comprenant :
le QFP (100) selon l'une quelconque des revendications précédentes ; et
une carte (200) sur laquelle le QFP (100) est monté.

8. Ensemble de carte de circuit imprimé (10) selon la revendication 7, dans lequel la pale (110) sert de masse.

9. Ensemble de carte de circuit imprimé (10) selon la revendication 7, dans lequel la carte (200) est une carte à une seule couche (200).
